Europäisches Patentamt

European Patent Office

Office européen des brevets

(11) Publication number: **0 148 784**
**B1**

# EUROPEAN PATENT SPECIFICATION

(45) Date of publication of patent specification: 05.07.89

(51) Int. Cl.⁴: **H 01 J 37/304,**
H 01 J 37/317, H 01 J 37/153

(21) Application number: 85300157.6

(22) Date of filing: 10.01.85

(54) Calibration of electron beam apparatus.

(30) Priority: 10.01.84 JP 3081/84

(43) Date of publication of application:
17.07.85 Bulletin 85/29

(45) Publication of the grant of the patent:
05.07.89 Bulletin 89/27

(84) Designated Contracting States:
DE FR GB

(56) References cited:
EP-A-0 030 347
GB-A-2 002 547
GB-A-2 059 120
US-A-4 336 597

PATENTS ABSTRACTS OF JAPAN, vol. 5, no.
55 (E-52)727r, 16th April 1981; & JP-A-56 7341
PATENTS ABSTRACTS OF JAPAN, vol. 7, no.
62 (E-164)1207r, 15th May 1983; & JP-A-57 208
140

(73) Proprietor: FUJITSU LIMITED
1015, Kamikodanaka Nakahara-ku
Kawasaki-shi Kanagawa 211 (JP)

(72) Inventor: Yasuda, Hiroshi c/o FUJITSU LIMITED
Patent Department 1015 Kamikodanaka
Nakahara-ku Kawasaki-shi Kanagawa 211 (JP)
Inventor: Miyazaki, Takayuki c/o FUJITSU
LIMITED
Patent Department 1015 Kamikodanaka
Nakahara-ku Kawasaki-shi Kanagawa 211 (JP)

(74) Representative: Sunderland, James Harry et al
HASELTINE LAKE & CO Hazlitt House 28
Southampton Buildings Chancery Lane
London WC2A 1AT (GB)

Courier Press, Leamington Spa, England.

## Description

The present invention relates to calibration of electron beam apparatus.

Electron beam exposure is widely used for making masks or for pattern exposure in semiconductor device production, especially in the production of integrated circuits (IC) or large scale integrated (LSI) circuits. As the rate (scale) of integration increases, for example to provide very large scale integrated (VLSI) circuits, a pattern to be exposed on a chip becomes fine and large. For example, chip sizes in excess of $10 \times 10$ mm², and line widths to be exposed of less than a μm, have to be dealt with. For such large chips and such fine patterns, aberration and distortion of electron beams are becoming limiting factors for pattern exposure.

To mitigate these difficulties, the pattern of a chip is subdivided into a plurality of sub-patterns, and exposure is effected in respect of these sub-patterns one by one, shifting exposure from sub-pattern to sub-pattern.

A main pattern and a sub-pattern of a chip are known in the art as "main field" and "sub-field" respectively.

However, even for such a subdivided pattern (field), aberration and distortion represent limiting factors on resolution. Moreover, it is undesirable to divide the field into many sub-fields, because this increases the time required to expose the entire field and increases errors due to subdivision. Therefore, it is desirable to decrease aberration and distortion so that they are as small as possible over a wide scanning area.

Errors in images exposed by electron beam can be divided into errors due to aberration and errors due to distortion. Aberration includes astigmatism, field curvature of focus, coma aberration and transverse chromatic aberration. Of these, coma and transverse chromatic aberrations are almost intrinsic for the electron beam apparatus employed and are determined by the design of its focusing system, and are difficult to correct. On the other hand, astigmatism and field curvature of focus are capable of being corrected together with distortion. Therefore, most modern electron beam exposers are provided with correction coils to correct such errors.

Another bottleneck in electron beam exposure is processing speed, because more than a million exposure shots are required to expose the entire surface of a slice. Therefore, exposure is controlled by computer and the process is generally automated. However, the above-mentioned correction for astigmatism and field curvature of electron beam is still effected manually. Thus, correction is effected only in respect of the center or in respect of a few predetermined spots of a sub-pattern, and the whole sub-pattern is exposed using correction factors applicable to such spots. The inventors know of very few attempts to perform calibrations in respect of several points in a pattern with the aid of a computer, and even in such attempts calibration for other parts of the deflection field is effected using appropriate interpolation or mean values of the correction factors applicable to these several points. Previously, therefore, it has been impossible to attain the best resolution with an electron beam over the entire surface of the chip to be exposed.

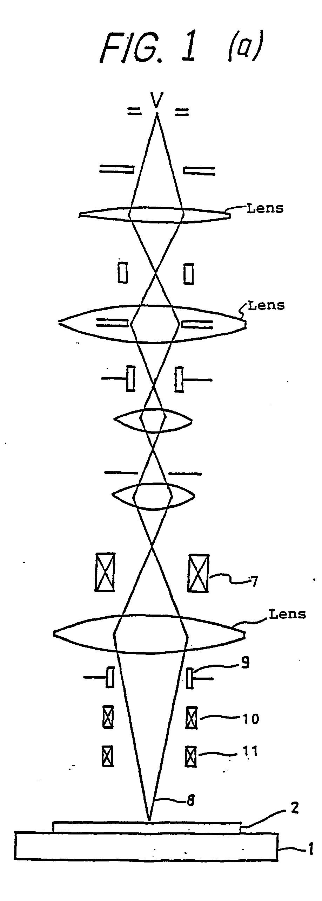

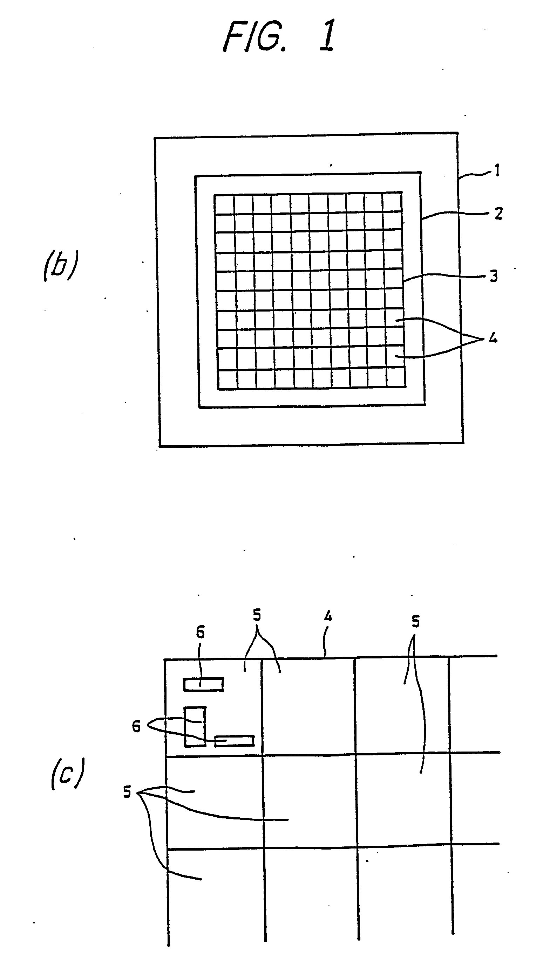

To clarify advantages of the present invention, a previous method of electron beam exposure will be described briefly. Fig. 1(a), (b) and (c) are for assistance in explaining a previous method of electron beam exposure of an IC substrate. Explanation will be given in respect of those matters pertinent to the present invention.

As shown in Fig. 1(a), which is a schematic view of electron beam exposure apparatus, an IC slice 2 is mounted on a table 1 which is slidable in X and Y directions; this table is called the XY-table. An electron beam 8 is focused on the surface of the slice 2 by an electron beam lens system. Using a main deflector 7 and a sub-deflector 9, the electron beam 8 is scanned over the substrate (IC slice) to expose a chip with a predetermined pattern. When the exposure of a chip is completed, the XY-table 1 slides one chip pitch to bring the next chip to the exposure area (main field).

Fig. 1(b) is a schematic plan view of an IC slice 2 placed on the XY-table 1. Slice 2 does not always have a square shape as shown in the Figure; usually it has a circular form. A patterning area 3 of the slice 2 is divided into a plurality of main fields 4, as shown in the Figure. Each main field corresponds to one IC chip, so a plurality of chips are to be fabricated from the slice. Exposure is performed for each main (field) frame (chip), and when the exposure is completed, the XY-table slides one main field pitch.

Each main field 4 is further divided into a plurality of sub-fields 5 as shown in Fig. 1(c) which is a schematic plan view to a scale enlarged in comparison to Fig. 1(b). The electron beam 8 is deflected by main deflector 7 to each of the sub-fields. Each sub-field is scanned by the electron beam 8 using the sub-deflector 9, and patterns 6 are exposed. When exposure of a sub-field is completed, the beam is deflected to a next sub-field. In such a manner, when all sub-fields are exposed, it means that a chip is entirely exposed, and the XY-station (table) slides to bring a next main (field) frame (chip) into the exposure area.

Referring back to Fig. 1(a), the Figure also illustrates schematically a part of an electron beam exposer which is related to the present invention. Recent electron beam exposers are provided with means for correcting astigmatism and field curvature of focus. These means are illustrated by coils 10 and 11. Coil 10 corrects astigmatism, and is called a stigmator coil. Coil 11 corrects field curvature of focus. Calibration is effected by adjusting current running through these coils. The present invention is related to the operating of such correction means, but does not relate to the structure of such means, so description of details of these coils and of details of the structure of the electron beam exposer will be omitted for the sake of simplicity.

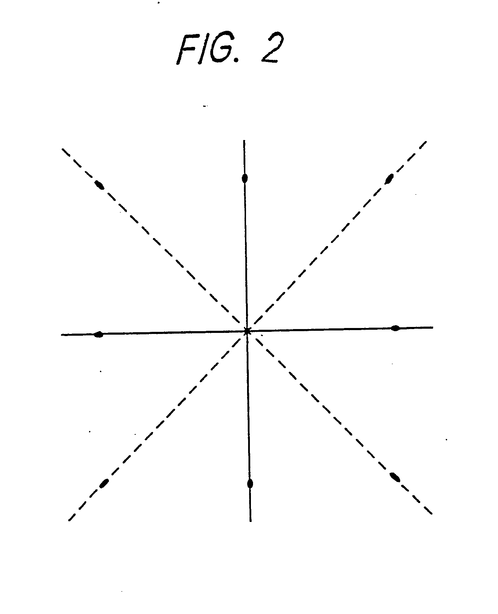

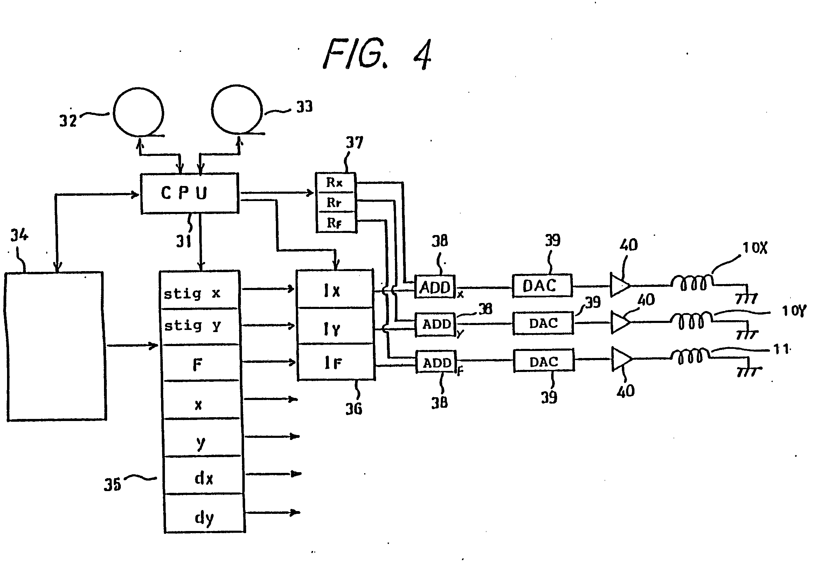

Astigmatism provides an aberration as illustrated in Fig. 2. The Figure gives a plan view showing the form of a beam spot when the spot is located at various parts of a scanning area, emphasizing deformation of the spot. As shown in the Figure, though the beam is focused as a circular point at the center of the scanning area, the beam spot is deformed to take an oval shape when the beam is deflected away from the centre. The deformation of the spot can be corrected by varying stigmator coil current (coils 10x and 10y described below with reference to Fig. 4). However, since the deformation of the beam spot varies from point to point over the scanning area, correction current should be varied in dependence upon the point of the scan at which the beam spot is located.

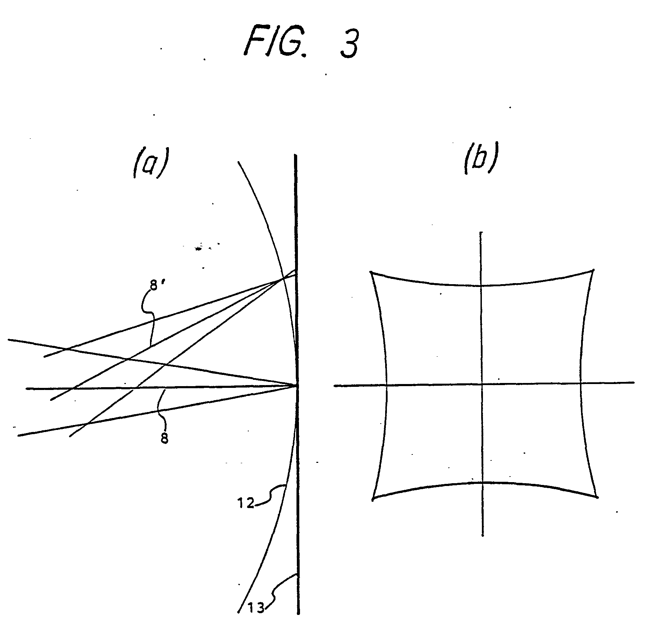

Aberration due to field curvature of focus is illustrated in Fig. 3(a) and (b). Fig. 3(a) shows schematically a side view of an electron beam. Generally the electron beam is focused on a spherical surface 12, whose radius of curvature is related to the focal length of the electron lens system forming the beam. So, if electron beam 8 is focused on the center of a main field 13 and then it is deflected to 8', the beam spot will blur as illustrated in the Figure. At the same time a square pattern, for example, will be deformed as shown in Fig. 3(b). Such aberration as is shown in Fig. 3(a) can be corrected by adjusting the current of the coil 11. Pattern curvature as shown in Fig. 3(b) is not aberration, but is a deformation, so it can be corrected by adjustment of sub deflector 9 altogether with other deformations. The present invention is concerned with correction of aberration of an electron beam spot due to astigmatism (Fig. 2) and aberration due to the field curvature of focus (Fig. 3(a)). It will be clear that such aberration is desirably corrected in respect of every point in a scanning area in order to attain maximum resolution over the entire field of scanning.

Astigmatism and field curvature of focus are theoretically different phenomena and are independent of each other. However, in practice, if one of them is corrected by a correction means (coils), the other is affected by this correction, so there is a correlation between the phenomena so far as correction means is concerned. This makes calibration more difficult.

Fig. 4 shows a schematic block diagram of a system for calibrating astigmatism and field curvature of focus. There may be many types of system suitable for this purpose, so the Figure shows what is believed to be a representative system in most respects. The system comprises a computer 31 which is a central processing unit (CPU). The CPU 31 controls not only calibration, but it also aids the operator in obtaining correction factors. The CPU 31 also controls the whole system of electron beam exposure. For example, control of the XY-table, deflection and scanning of electron beam, and on-off switching of electron beam to expose a pattern are all controlled by this CPU. However, these control functions are not related to the present invention, so they are omitted from description for the sake of simplicity.

In the example of Fig. 4, pattern data which describes the position and size of patterns is stored on a magnetic tape 32, and correction data which describes correction factors for each beam position is stored in a magnetic tape 33. Before starting exposure, the CPU 31 reads out such data and stores the pattern data and the correction data respectively in a pattern data buffer memory 34 and a correction data memory 35.

Correction data stored in the memory 35 includes:

stig x, correction data for astigmatism in an X direction;

stig y, correction data for astigmatism in a Y direction;

focus F, correction data for aberration due to the field curvature of focus; and

other correction data such as data for correction of shrinkage or expansion of sub-fields (denoted x and y in the Figure), and distortions (denoted dx and dy in the Figure).

This data is used for correction under the control of the CPU 31. However, only the use of stig x, stig y and focus F will be described herein, because the other correction factors are not the direct concern of the present invention.

When exposure begins, the CPU assigns a subfield and pattern position. Then correction data stig x, stig y and F corresponding to the sub-field and pattern position (that is, a beam position to which the electron beam is deflected) is taken out from the correction data memory 35 and sent to a register 36, where they are stored respectively as values of current to be caused to flow in stigmator coils 10x, 10y and focus correction coil 11 (denoted as Ix, Iy and IF respectively). These data values are sent to respective digital analog converts (DAC) 39, via adders (ADD) 38, and converted to analog signals and amplified by respective amplifiers 40 and fed to coils 10x, 10y and 11 respectively. At the same time, the CPU 31 controls the electron beam exposer to deflect the beam 8 to the position determined by the pattern data. So, the beam is corrected by the correction data stored on the magnetic tape 33.

It is to be noted that the system of Fig. 4 is shown to be provided with an additional register 37 (and adders 38). This additional register (and adders) is provided in an embodiment of the present invention for computer aided measurement. Operation of the register 37 and the adders 38 will be explained later in connection with an embodiment of the present invention.

The real problem is how to obtain the correction data, in other words how to obtain the data stored in the correction data memory 35 in Fig. 4. The present invention concerns the obtaining of the data for stig x, stig y and focus F. As mentioned above, these correction factors are correlated to each other, so it is very difficult to obtain optimum points (data giving optimum correction).

Correction data is obtained from measurements of sharpness of the electron beam. Various methods may be designed for measuring the sharpness of an electron beam. One example will be explained with reference to Figs. 4 to 7. The measurement can be carried out manually or with the aid of a computer. First it will be explained how the sharpness of a beam spot is determined and how it is measured.

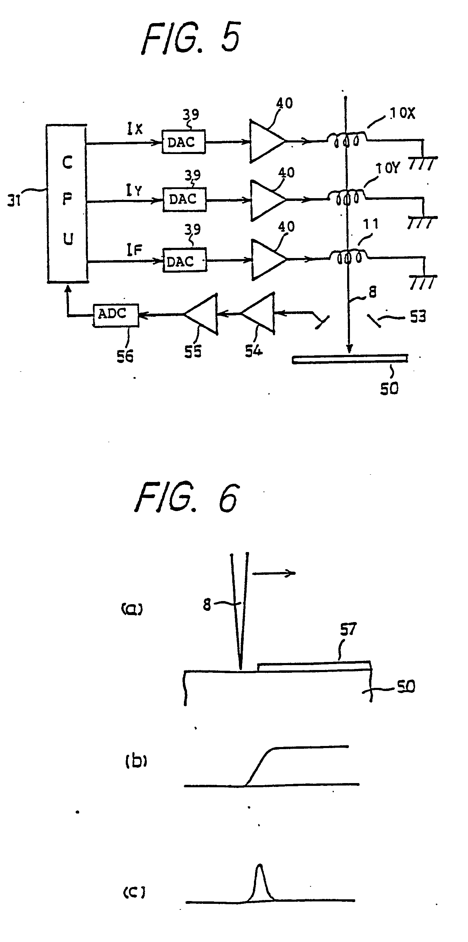

Fig. 5 shows schematically a part of an electron beam exposer with which the present invention is primarily concerned. In the Figure, 53 designates a detector which collects scattered electron beams from the surface of a substrate 50. The detector may alternatively be a secondary electron collector or an electron collector for the beam transmitted through the substrate. Recent electron beam exposers are provided with such detectors. Explanation will be given with respect to a scattered electron detector hereinafter. The substrate 50 has a test mark on its surface.

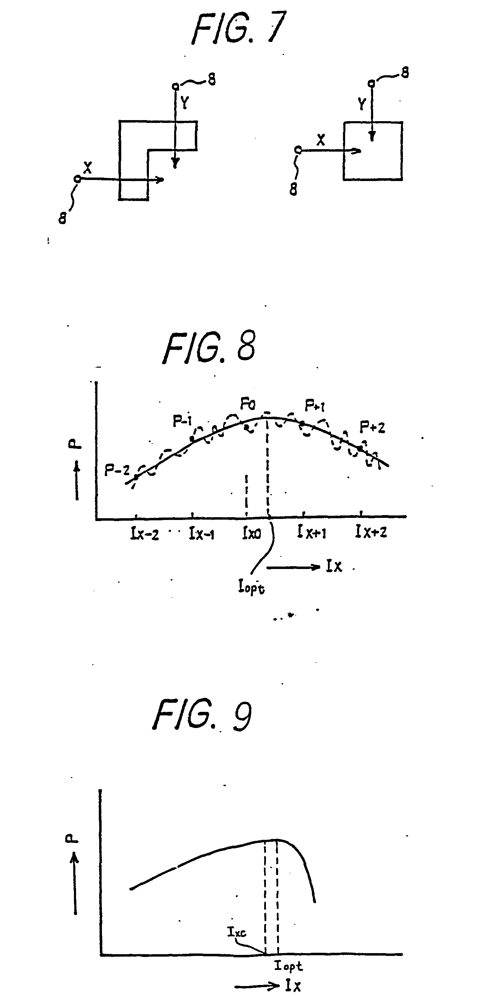

Examples of test marks are shown in Fig. 7. A test mark is made from tantalum or gold film. The overall size of a test mark is approximately 5 to 50 μm square.

Scanning the electron beam 8 over the test mark, the scattered electrons are collected by the collector 53, and amplified by an amplifier 54. Fig. 6(a) illustrates this situation with a side view of the electron beam 8. When the electron beam 8 crosses the edge of the test mark (57 in Fig. 6(a)) the current of the scattered electrons varies as shown in Fig. 6(b). Since the electron beam 8 has a spot size (not shown in the Figure), the measured current varies with a slope at the edge of the test mark as shown in the Figure. This slope corresponds to the spot size (spot width in the direction of deflection of the electron beam); that is, the sharpness of the electron beam 8 at the position of the mark edge. If the current is differentiated with respect to time (which corresponds to the position x or y) by a differential circuit 55, its output provides a pulse as shown in Fig. 6(c). The size of this pulse corresponds to the sharpness of the electron beam. Such measurement can be effected manually or with the aid of CPU 31, in Fig. 5. In this case the output of the differential circuit 55 is fed to an analog digital converter (ADC) 56, and then send back to the CPU 31 for calculation of a correction factor.

Fig. 5 shows schematically how astigmatism and field curvature of focus are corrected in a previously proposed electron beam exposer. In the Figure, 10X and 10Y designate the stigmator coils for correcting astigmatism in X and Y directions. They are respectively composed of four coils (not shown) each connected in series, and construct an electron lens. The axes of the electrons lens 10X and 10Y are set orthogonally to the axis of the electron beam 8, and are aligned to cross each other with an angle of 45°. By adjusting the current running through these coils, it is possible to correct the deformation of beam spot due to the astigmatism. The coil 11 constitutes another lens which corrects aberration of focus due to the field curvature of focus, by adjusting the current running through the coil.

The correction data is obtained as follows. Deflecting the electron beam in X and Y directions at a proper edge of the test mark as shown in Fig. 7, which is brought to a position in relation to which correction data is to be obtained, the sharpness of the beam is measured as described above, manually or with the aid of CPU. For example, at first a sharpness $p_x$ for the X direction is measured, keeping $I_y$ the correction current for the stigmator 10Y and $I_F$ the correction current for the coil 11 constant. Next, $I_x$ the correction current for the stigmator 10X is varied. The sharpness $p_x$ will consequently vary. The current $I_x$ giving a maximum value of $p_x$ is determined. Generally, this value is considered as the correction factor for the coil 10X. Similarly the correction factors for the coils 10Y and 11 are determined respectively, keeping the correction currents for other coils constant whilst varying the current for each coil concerned.

However, as has been mentioned before, there are correlations between these corrections. Thus, if the maximum value of $p_x$ is measured under a condition in which $I_y$ and $I_F$ have particular values then, for example, the value of $p_x$ will vary when $I_y$ or $I_F$ is varied. In order to avoid this problem, the above process of measurement has been repeated several times, each time maintaining the correction currents of the coils other than that for which a correction factor is being newly determined to the currents obtained in the previous measurement. Thus, the calibration has been brought to an optimum value asymptotically by repeating measurements.

Therefore, it has taken considerable time to obtain the calibration or correction factors. So, usually, measurement has been carried out only in relation to one point per sub-frame (field), or to several points per main frame (field). Calibration for other parts of the chip has been effected using such data or using a mean or proper interpolation of such data. It has been impossible, therefore, to obtain optimum focusing conditions over the entire surface of a chip, and it has been impossible to attain a maximum resolution of the electron beam exposer. Moreover, although it is possible theoretically to calibrate the focusing at all points over the chip, it is necessary in practice to renew correction data occasionally, for instance once a week or once a day, before the beginning of exposure processing, in order to attain highest possible resolution. This is because the stability of the apparatus used is very critical. Such calibration, therefore, has been impossible and impractical for previous electron beam exposers.

According to the present invention there is provided a method of calibrating an electron beam apparatus, which apparatus is operable to scan an electron beam in an X-direction and in a Y-direction orthogonal to said X-direction over the surface of a specimen, said calibrating being accomplished by determining optimum values of respective correction currents to be supplied to correction coils provided in the apparatus for correcting aberration due respectively to X-direction astigmatism, Y-direction astigmatism, and field curvature of focus, the method comprising the steps of directing the electron beam at a predetermined location on said surface and

(a) varying a first one of the said correction currents whilst maintaining the other two of the said correction currents constant so that the said one correction current takes a plurality of different values;

(b) for each different value of the said one correction current, calculating a corresponding value of a combination sharpness of the electron beam, which combination sharpness is defined by the product of measures of the transverse dimensions of the beam spot in the X- and Y-directions respectively at the said predetermined location;

(c) determining an optimum value of the said one correction current in dependence of the calculated values of the combination sharpness;

(d) twice repeating steps (a) to (c) in sequence, but varying in the first repeat a second one and in the second repeat a third one of the said correction currents, maintaining the other two of the said correction currents constant in each repeat;

(e) carrying out steps (a) to (d) in sequence one or more times until the obtained values of the said correction currents converge to a set of stable values.

According to the present invention there is provided a method of calibrating an electron beam apparatus, which apparatus is operable to scan an electron beam in an X-direction and in a Y-direction orthogonal to said X-direction over the surface of a specimen, said calibrating being accomplished by determining optimum values of respective correction currents to be supplied to correction coils provided in the apparatus for correcting aberration due respectively to X-direction astigmatism, Y-direction astigmatism, and field curvature of focus, the method comprising the steps of directing the electron beam at a predetermined location on said surface and

(a) varying a first one of the said correction currents whilst maintaining the other two of the said correction currents constant so that the said one correction current takes a plurality of different values;

(b) for each different value of the said one correction current, calculating a corresponding value of a combination sharpness of the electron beam, which combination sharpness is defined by the sum of the squares of measures of the transverse dimensions of the beam spot in the X- and Y-directions respectively at the said predetermined location;

(c) determining an optimum value of the said one correction current in dependence on the calculated values of the combination sharpness;

(d) twice repeating steps (a) to (c) in sequence, but varying in the first repeat a second one and in the second repeat a third one of the said correction currents, maintaining the other two of the said correction currents constant in each repeat;

(e) carrying out steps (a) to (d) in sequence one or more times until the obtained values of the said correction currents converge to a set of stable values.

According to the present invention there is provided a method of calibrating an electron beam apparatus, which apparatus is operable to scan an electron beam in an X-direction and in a Y-direction orthogonal to said X-direction over the surface of a specimen, said calibrating being accomplished by determining optimum values of respective correction currents to be supplied to correct coils provided in the apparatus for correcting aberration due respectively to X-direction astigmatism, Y-direction astigmatism, and field curvature of focus, the method comprising the steps of directing the electron beam at a predetermined location on said surface and

(a) varying a first one of the said correction currents whilst maintaining the other two of the said correction currents constant so that the said one correction current takes a plurality of different values;

(b) for each different value of the said one correction current, calculating a corresponding value of a combination sharpness of the electron beam, which combination sharpness is defined by the sum of the magnitudes of measures of the transverse dimensions of the beam spot in the X- and Y-directions respectively at the said predetermined location;

(c) determining an optimum value of the said one correction current in dependence on the calculated values of the combination sharpness;

(d) twice repeating steps (a) to (c) in sequence, but varying in the first repeat a second one and in the second repeat a third one of the said correction currents, maintaining the other two of the said correction currents constant in each repeat;

(e) carrying out steps (a) to (d) in sequence one or more times until the obtained values of the said correction currents converge to a set of stable values.

An embodiment of the present invention can provide a calibration method for an electron beam exposer by which correction factors can easily be obtained.

An embodiment of the present invention can provide a calibration method for an electron beam exposer by which a correction factor can be quickly obtained.

An embodiment of the present invention can provide a calibration method for astigmatism and field curvature of focus in electron beam apparatus over the entire surface of a scanning field.

An embodiment of the present invention can provide a method which enables precise data for the correction of an electron beam exposer to be obtained.

An embodiment of the present invention can facilitate operation of an electron beam exposer at or more nearly at its maximum resolution at every point of a scanning field.

An embodiment of the present invention can provide for adjustment of electron beam apparatus to minimize aberration due to astigmatism and field curvature of focus. An embodiment of the present invention provides a calibration method for current to be fed to correction coils of electron beam apparatus.

In an embodiment of the present invention a new category of sharpness P, which is for instance a product of sharpnesses (measures of transverse dimensions of the beam spot) for X and Y directions as employed in the previous method described above, is employed. By using this new category of sharpness, it is possible to obtain the correction factors with a very good convergence to optimum values, and practically they can be obtained with only one sequence of measurement (for each point in the scanning field). Thus, it is easy to include the measurement of sharpness and calibration of currents for correction coils in the process of CPU controlled exposure.

In an embodiment of the present invention the preciseness of the measurement of sharpness can be increased. The preciseness is increased by using a rectangular beam (electron beam spot) for measurement of sharpness. When the beam is scanned in X direction to obtain an X-direction sharpness $p_x$, the beam shape is elongated in the Y direction, and when the beam is scanned in a Y direction to obtain a Y-direction sharpness $p_y$, the rectangular beam is elongated in the X direction.

In an embodiment of the present invention correction factors can be obtained without being misled by noise or fluctuation of the apparatus. For this purpose, in an embodiment of the present invention, sharpness is measured at relatively (widely) separate points of correction current, and the optimum value is calculated by a least squares method approximating the measured values to a quadratic curve.

Reference is made, by way of example, to the accompanying drawings, in which:

Figs. 1 are for assistance in explaining a previous method of electron beam exposure,

Fig. 1(a) illustrates schematically an electron beam exposer and how a substrate is exposed by an electron beam using the exposer,

Fig. 1(b) is a schematic plan view of a substrate showing how it is divided into a plurality of main fields for exposure of the entire surface of the substrate, and

Fig. 1(c) is an expanded schematic plan view of a part of the substrate, illustrating how a main field is further divided into a plurality of subfields, and how the patterns are scanned and exposed,

Fig. 2 is a schematic diagram illustrating deformation of an electron beam spot caused by astigmatism,

Figs. 3 are for assistance in explaining field curvature of focus,

Fig. 3(a) is a schematic beam diagram illustrating how aberration occurs due to field curvature of focus, and

Fig. 3(b) schematically illustrates a deformed pattern arising due to field curvature of focus,

Fig. 4 is a schematic block diagram of a control system for an electron beam exposer, illustrating in particular parts related to correction of aberration due to astigmatism and field curvature of focus,

Fig. 5 is a schematic block diagram illustrating a main part of a system employed for measuring electron beam sharpness and for calibrating aberrations,

Figs. 6 are for assistance in explaining a method of measuring sharpness of an electron beam,

Fig. 6(a) is a schematic side view of an electron beam scanning over a test mark,

Fig. 6(b) graphically illustrates variation of scattered electron current at the edge of the test mark, and

Fig. 6(c) graphically illustrates a curve indicating sharpness of an electron beam,

Fig. 7 schematically illustrates test marks applicable for the measurement of sharpness,

Fig. 8 is a graph illustrating a method of obtaining an optimum value of a correction factor $I_x$ from measured values of sharpness P, by a method embodying the present invention, and

Fig. 9 is a graph showing a curve illustrating how an optimum value of a correction factor $I_x$ is obtained for an uneven curve of measured values of sharpness P.

In accordance with an embodiment of the present invention, correction factors for aberration due to astigmatism and field curvature of focus are obtained as follows. Referring to Fig. 4, pattern data and correction data stored in magnetic tapes 32 and 33 are transferred to a pattern data buffer memory 34, and a correction data memory 35 respectively, and stored there together with other correction factors under the control of the CPU 31. The correction data values so stored are values which are obtained from a previous measurement (of correction factors): if a first measurement is yet to be made these data values are zero. When a position (X, Y coordinates) in relation to which calibration is to be effected is appointed by the CPU 31, correction data stig x, stig y and F respectively for astigmatism in X, Y directions and the field curvature of focus at the appointed position are taken out from the correction data memory 35 and sent to a register 36, and stored there as correction current data values $I_x$, $I_y$ and $I_F$ written in digital form, in a manner similar to that described above with respect to the previous method. At the same time the electron beam 8 is deflected to the appointed position by main deflector 7 and sub-deflector 9 which are under the control of the CPU 31. The details of the control method for the electron beam will not be described herein, since it may be a conventional control method.

The electron beam 8 is corrected using data values $I_x$, $I_y$ and $I_F$ in the same manner as with the previous method. Namely, correction currents are supplied in accordance with these data values to respective coils 10X, 10Y and 11 via adders 38, digital to analog converters 39 and amplifiers 40. The above steps are all similar to those of the previous method. The measurement of correction factors in accordance with an embodiment of the present invention starts from this situation.

A test mark, examples of which are given in Fig. 7, is moved by the XY-table 1 and brought to an appointed position in respect of which calibration is to be effected. This movement is performed under the control of the CPU 31 in ordinary manner. Then the measurement begins.

Superposing a small AC voltage on the sub-deflector 9, the electron beam spot is slightly deflected in X and Y directions so that it crosses the edge of the test mark in X and Y directions as shown in Fig. 7. Then in a same manner as described with respect to the previous method, sharpnesses (measures of beam spot transverse dimensions) $p_x$ in the X direction and $p_y$ in the Y direction are measured. Upon receiving this data, the CPU 31 calculates a product of those sharpnesses and defines a new category of sharpness P as

$$P = p_x \times p_y.$$

Using this new category of sharpness, in accordance with an embodiment of the present invention optimum value of correction factors are determined.

An explanation will be given with respect to an example of the measuring process for obtaining the correction factor stig x. Let the previous value of the sharpness P be $P_0$. Keeping the values of $I_y$ and $I_F$ constant (for these values there are used the data values obtained in a previous calibration) the value of $I_x$ is varied. Namely, the CPU 31 commands the second register 37 to send a first number $R_{x1}$ stored in it to the adder 38. Explanation regarding the numbers stored in the second register 37 will be given below. Then, in the adder 38x, the values of $I_x$ and $R_{x1}$ are added to each other to provide a new value $I_{x+1}$ of $I_x$. For this new value of $I_x$ the sharpness P is measured. Let the new value of P be $P_1$. When $P_1$ is measured, the CPU 31 commands the second register 37 to send a second number $R_{x2}$ to the adder 38x. Then sharpness $P_2$ for the new value of (correction current) $I_{x+2}$ is measured. In like manner, sharpness P is measured for various other currents $I_x$.

Fig. 8 shows graphically an example of measured values of P for various values of $I_x$. In Fig. 8, $P_0$ is the value of P measured for the value of $R_{x0}$ that is zero, so it corresponds to the value of P measured for the previous correction current $I_{x0}$, which has been stored in the magnetic tape 33. By changing the sign of $R_x$ from + to −, values $I_{x-1}$,

$I_{x-2}$ and $P_{-1}$ and $P_{-2}$ are obtained. It will be understood from the above explanation that the value of the number $R_x$ determines the difference of $I_x$ between measurements, in other words it indicates distance between measuring points on the horizontal axis in the graph of Fig. 8.

In the second register 37 are stored not only the number $R_x$ for measuring stig x, but also numbers $R_y$ and $R_F$ respectively used for the measurement of stig y and focus F. They are used in a similar manner to that described for $R_x$ above.

In practice, a measured value of the sharpness includes error and noise. So, if sharpness is measured with only a short distance (on the horizontal axis in Fig. 8) between measuring points, the data will form an irregular curve as indicated by the broken line in Fig. 8. It is meaningless therefore, to measure P over a short range. Moreover, if sharpness is measured over a very small distance, there occurs a possibility of misunderstanding a small peak or small valley of the irregular curve as corresponding to a maximum or minimum value of P.

The value of $R_x$ is to be determined empirically, but from the experience of the inventors, it is effective to select the value of $R_x$ so that the measured value of P varies about 5—10% from that of the previous measurement. The optimum value is obtained by calculation utilizing a least square method. In this case, it is effective to approximate the measured curve of P (solid line of Fig. 8) with a quadratic curve. Only five measurements for P are shown in Fig. 8 and this number of measurements is sufficient.

It was found that by using the new category of sharpness P, the convergence of the measured value to the optimum value is very good, even though there are correlations between $I_x$, $I_y$ and $I_F$. Usually only one sequence of measurement for one point is sufficient. In rare cases, when all values of $I_{x0}$, $I_{y0}$ and $I_{F0}$ are zero, that means the beginning of the new pattern generation, two or three sequences of measurement are required in respect of a point or appointed beam position. Namely, at first $I_x$ is determined keeping $I_y$ and $I_F$ at zero, then $I_y$ is determined using the determined $I_x$, next $I_F$ is determined using the determined $I_x$ and $I_y$. Measurement is repeated using the new values of $I_x$, $I_y$ and $I_F$ respectively. However, since convergence of data is very good, usually two sequences of measurement provide the final value.

In a manner similar to that described above for $I_x$, optimum values of $I_y$ and $I_F$ are obtained. Command for the measurements and calculations is performed by the CPU 31. Details will be omitted since they are an ordinary application of a computer. The calculated optimum values of $I_x$, $I_y$ and $I_F$ are stored in the memory of the CPU until all measurements for other measuring points are completed, and then they are sent to the magnetic tape 33 and replace the former values thereon.

Sometimes, there occurs a case in which measured value of P varies unevenly with respect to the correction current ($I_x$ for example) as shown graphically by the curve in Fig. 9, where a maximum value of P is located very close to a sharp fall of the curve. In such case the actual correction current $I_{xc}$ should be determined to have a value slightly apart from the nominal optimum value $I_{opt}$ (corresponding to the maximum value of P), to the left side in the Figure, to avoid instability of the apparatus. for such purpose, the above described least square method is very convenient and practical. Approximation to a quadratic curve gives automatically a separate point from the nominal optimum value $I_{opt}$. This is a feature of the least squares method of approximation. If approximation is carried out more precisely, with higher order curves, the calculation will give the correct (nominal) value of $I_{opt}$. However, this is not desirable from the point of view of stability.

In the above method for obtaining the correction factors, it is desirable to use a variable rectangular beam whose sides are oriented in X and Y directions. Such variable rectangular beams are widely used in recent electron beam exposers. Using such a beam, to measure $p_x$, the sharpness in X direction, the beam 8 is elongated in the Y direction and deflected in the X direction as shown in Fig. 7. On the other hand, when the beam 8 is deflected in the Y direction to obtain $p_y$, the sharpness in Y direction, the beam is elongated in X direction. By doing this, it will be clear that the variation of scattered electron current as shown in Fig. 6(b) becomes sharper, and the pulse of the curve in Fig. 6(c) becomes higher. So, a higher accuracy of data is available.

In the above description, sharpness is determined by the height of the pulse of Fig. 6(c), and the new category of sharpness is defined as the product of $p_x$ and $p_y$. However, it is alternatively possible to define new categories of sharpness P' or P'' where

$$P' = p_x^2 + p_y^2$$

or

$$P'' = |p_x| + |p_y|$$

and use them in the place of P. It is also possible to define sharpness in terms of the width of the pulse of Fig. 6(c). With such a modification, it will be clear that the optimum value of $I_x$ etc. should be obtained from the minimum points of curves corresponding to those of Fig. 8 or 9.

Furthermore, though the measurement of the sharpness of the beam and correction of the aberration become very easy, it is unnecessary to calibrate the beam at all points. Practically, it is sufficient to calibrate the beam at a number of predetermined matrix points for each sub-field. Calibration for other points can then be performed using calibration factors which connect smoothly the measured values. There are many methods applicable for this purpose, interpolation, extrapolation and so on.

As has been described above, it will be clear that by the use of a method embodying the present invention it becomes easy and simple to obtain correction factors for aberrations due to astigmatism and field curvature of focus. This makes it possible to calibrate an electron beam at many points in a field of scanning, to obtain maximum resolution or to obtain nearly maximum resolution of the apparatus. The description above has been given with respect to an electron beam exposer, but calibration methods according to the embodiments of the present invention can be applied to any kind of electron beam apparatus.

## Claims

1. A method of calibrating an electron beam apparatus, which apparatus is operable to scan an electron beam (8) in an X-direction and in a Y-direction orthogonal to said X-direction over the surface of a specimen (2, 50), said calibrating being accomplished by determining optimum values of respective correction currents ($I_x$, $I_y$, $I_F$) to be supplied to correction coils (10X, 10Y, 11) provided in the apparatus for correcting aberration due respectively to X-direction astigmatism, Y-direction astigmatism, and field curvature of focus, the method comprising the steps of directing the electron beam at a predetermined location (X, Y) on said surface and

(a) varying a first one of the said correction currents whilst maintaining the other two of said correction currents constant so that the said one correction current takes a plurality of different values;

(b) for each different value of the said one correct current, calculating a corresponding value of a combination sharpness (P) of the electron beam (8), which combination sharpness is defined by the product ($p_x \times p_y$) of measures ($p_x$, $p_y$) of the transverse dimensions of the beam spot in the X- and Y-directions respectively at the said predetermined location (X, Y);

(c) determining an optimum value of the said one correction current in dependence on the calculated values of the combination sharpness;

(d) twice repeating steps (a) to (c) in sequence, but varying in the first repeat a second one and in the second repeat a third one of the said correction currents, maintaining the other two of the said correction currents constant in each repeat;

(e) carrying out steps (a) to (d) in sequence one or more times until the obtained values of the said correction currents converge to a set of stable values.

2. A method of calibrating an electron beam apparatus, which apparatus is operable to scan an electron beam (8) in an X-direction and in a Y-direction orthogonal to said X-direction over the surface of a specimen (2, 50), said calibrating being accomplished by determining optimum values of respective correction currents ($I_x$, $I_y$, $I_F$) to be supplied to correction coils (10X, 10Y, 11) provided in the apparatus for correcting aberration due respectively to X-direction astigmatism, Y-direction astigmatism, and field curvature of focus, the method comprising the steps of directing the electron beam at a predetermined location (X, Y) on said surface and

(a) varying a first one of the said correction currents whilst maintaining the other two of the said correction currents constant so that the said one correction current takes a plurality of different values;

(b) for each different value of the said one correction current, calculating a corresponding value of a combination sharpness (P') of the electron beam (8), which combination sharpness is defined by the sum of the squares $(p_x^2+p_y^2)$ of measures $(p_x, p_y)$ of the transverse dimensions of the beam spot in the X- and Y-directions respectively at the said predetermined location (X, Y);

(c) determining an optimum value of the said one correction current in dependence on the calculated values of the combination sharpness;

(d) twice repeating steps (a) to (c) in sequence, but varying in the first repeat a second one and in the second repeat a third one of the said correction currents, maintaining the other two of the said correction currents constant in each repeat;

(e) carrying out steps (a) to (d) in sequence one or more times until the obtained values of the said correction currents converge to a set of stable values.

3. A method of calibrating an electron beam apparatus, which apparatus is operable to scan an electron beam (8) in an X-direction and in a Y-direction orthogonal to said X-direction over the surface of a specimen (2, 50), said calibrating being accomplished by determining optimum values of respective correction currents ($I_x$, $I_y$, $I_F$) to be supplied to correction coils (10X, 10Y, 11) provided in the apparatus for correcting aberration due respectively to X-direction astigmatism, Y-direction astigmatism, and field curvature of focus, the method comprising the steps of directing the electron beam at a predetermined location (X, Y) on said surface and

(a) varying a first one of the said correction currents whilst maintaining the other two of the said correction currents constant so that the said one correction current takes a plurality of different values;

(b) for each different value of the said one correction current, calculating a corresponding value of a combination sharpness (P'') of the electron beam (8), which combination sharpness is defined by the sum of the magnitudes ($|p_x|+|p_y|$) of measures $(p_x, p_y)$ of the transverse dimensions of the beam spot in the X- and Y-directions respectively at the said predetermined location (X, Y);

(c) determining an optimum value of the said one correction current in dependence on the calculated values of the combination sharpness;

(d) twice repeating steps (a) to (c) in sequence, but varying in the first repeat a second one and in the second repeat a third one of the said correction currents, maintaining the other two of the said correction currents constant in each repeat;

(e) carrying out steps (a) to (d) in sequence one or more times until the obtained values of the said correction currents converge to a set of stable values.

4. A method as claimed in claim 1, 2 or 3, wherein optimum values of the or each correction current ($I_x$, $I_y$, $I_F$) are obtained in respect of each of a plurality of predetermined matrix points in a field over which the electron beam is to be deflected in the course of scanning of the surface of a specimen, and correction currents for other points in the field are determined from the optimum values so obtained.

5. A method as claimed in any preceding claim, wherein obtained optimum values of the or each correction current are stored in memory means, and are replaced by new optimum values subsequently obtained, for example when the apparatus is recalibrated.

6. A method as claimed in any preceding claim, wherein the said one correction current is varied in step (a) in steps of a size such that the measured value of the combination sharpness varies by about 5% to 10% as between one value of the said one correction current, for example an optimum value previously stored in memory means in accordance with claim 5, and the value to which said one correction current is next stepped.

7. A method as claimed in any preceding claim, wherein, for measuring a value of the combination sharpness, measurements of the transverse dimensions of the beam spot in the X-direction and the Y-direction are performed by measuring variation of scattered electrons or secondary electrons from the surface of a specimen (50), or variation of transmitted electrons through the specimen (50), when the electron beam is deflected across an edge of a test mark provided on the specimen (50).

8. A method as claimed in any preceding claim, wherein the electron beam spot on the specimen is elongated in the Y direction when the transverse dimension of the spot in the X-direction ($p_x$) is measured, and the electron beam spot on the specimen is elongated in the X direction when the transverse dimension of the spot in the Y-direction ($p_y$) is measured.

9. A method as claimed in any preceding claim, wherein the optimum value of the said one correction current is determined in step (c) by a least squares method approximating the measured values of the combination sharpness to a quadratic curve.

**Patentansprüche**

1. Verfahren zur Eichung eines Elektronenstrahlgeräts, welches Gerät betreibbar ist, um einen Elektronenstrahl (8) in X-Richtung und in Y-Richtung, orthogonal zur genannten X-Richtung, über die Oberfläche einer Probe (2, 50) zu tasten, welche Eichung erreicht wird durch Bestimmung optimaler Werte der jeweiligen Korrekturströme ($I_x$, $I_y$, $I_F$), die den Korrekturspulen (10X, 10Y, 11) zugeführt werden, die dem Gerät zur Korrektur der Aberration, die auf X-Richtungs-Astigmatismus, Y-Richtungs-Astigmatismus bzw. Feldkrümmung der Brennweite beruht, welches Verfahren die Schritte der Richtung des Elektronenstrahls auf einen vorbestimmten Ort (X, Y) auf der genannten Oberfläche umfaßt, und

(a) Veränderung eines ersten der genannten Korrekturströme, während die anderen beiden der genannten Korrekturströme konstant gehalten werden, so daß der genannte eine Korrekturstrom eine Vielzahl von verschiedenen Werten annimmt;

(b) für jeden verschiedenen Wert des genannten Korrekturstromes, Berechnen eines entsprechenden Wertes einer Kombinationsschärfe (P) des Elektronenstrahls (8), welche Kombinationsschärfe definiert ist durch das Produkt $(p_x \times p_y)$ der Maße $(p_x, p_y)$ der transversalen Dimensionen des Strahlenpunkts in X- bzw. Y-Richtung bei dem vorbestimmten Ort (X, Y);

(c) Bestimmen eines optimalen Wertes des genannten einen Korrekturstroms in Abhängigkeit von den berechneten Werten der Kombinationsschärfe;

(d) zweifaches Wiederholen der Schritte (a) bis (c) in Folge, jedoch Veränderung eines zweiten der genannten Korrekturströme bei der ersten Wiederholung und eines dritten der genannten Korrekturströme bei der zweiten Wiederholung, Konstanthalten der beiden anderen der genannten Korrekturströme bei jeder Wiederholing;

(e) Ausführen der Schritte (a) bis (d) in Folge, ein oder mehrere Male, bis die erreichten Werte der genannten Korrekturströme auf einen Satz von stabilen Werten konvergieren.

2. Verfahren zur Eichung eines Elektronenstrahlgeräts, welches Gerät betreibbar ist, um einen Elektronenstrahl (8) in X-Richtung und in Y-Richtung, orthogonal zur genannten X-Richtung, über die Oberfläche einer Probe (2, 50) zu tasten, welche Eichung errecht wird durch Bestimmung von optimalen Werten von jeweiligen Korrekturströmen $(I_x, I_y, I_F)$, die Korrekturspulen (10X, 10Y, 11) zugeführt werden sollen, die in dem Gerät zum Korrigieren der Aberration, aufgrund von X-Richtungs-Astigmatismus, Y-Richtungs-Astigmatismus bzw. Feldkrümmung der Brennweite, vorgesehen sind, welches Verfahren die Schritte der Richtung eines Elektronenstrahls auf einen vorbestimmten Ort (X, Y) auf der genannten Oberfläche umfaßt, und

(a) Variieren eines ersten der genannten Korrekturströme, während die anderen beiden der genannten Korrekturströme konstant gehalten werden, so daß der genannte eine Korrekturstrom eine Vielzahl von verschiedenen Werten annimmt;

(b) für jeden verschiedenen Wert des genannten einen Korrekturstromes, Berechnen eines entsprechenden Wertes einer Kombinationsschärfe (P') des Elektronenstrahls (8), welche Kombinationsschärfe definiert ist durch die Summer der Quadrate $(p_x^2 + p_y^2)$ von Maßen $(p_x, p_y)$ der transversalen Dimensionen des Strahlenpunktes in X- bzw. Y-Richtung bei dem genannten vorbestimmten Ort (X, Y);

(c) Bestimmen eines optimalen Wertes des genannten einen Korrekturstroms in Abhängigkeit von den berechneten Werten der Kombinationsschärfe;

(d) zweifache Wiederholung der Schritte (a) bis (c) in Folge, jedoch Variieren eines zweiten der genanten Korrekturströme während der ersten Wiederholung und eines dritten der genannten Korrekturströme bei der zweiten Wiederholung, Konstanthalten der anderen beiden der genannten beiden Korrekturströme bei jeder Wiederholung;

(e) Durchführen der Schritte (a) bis (d) in Folge, ein oder mehrere Male, bis die erhaltenen Werte der genannten Korrekturströme auf einen Satz von stabilen Werten konvergieren.

3. Verfahren zur Eichung eines Elektronenstrahlgeräts, welches Gerät betreibbar ist, um einen Elektronenstrahl (8) in X-Richtung und in Y-Richtung, orthogonal zur genannten X-Richtung, über die Oberfläche einer Probe (2, 50) zu tasten, welche Eichung errecht wird durch Bestimmung von optimalen Werten von jeweiligen Korrekturströmen $(I_x, I_y, I_F)$, die Korrekturspulen (10X, 10Y, 11) zugeführt werden sollen, die in dem Gerät zum Korrigieren der Aberration, aufgrund von X-Richtungs-Astigmatismus, Y-Richtungs-Astigmatismus bzw. Feldkrümmung der Brennweite vorgesehen sind, welches Verfahren die Schritte der Richtung eines Elektronenstrahls auf einen vorbestimmten Ort (X, Y) auf der genannten Oberfläche umfaßt, und

(a) Variieren eines ersten der genannten Korrekturströme, während die anderen beiden der genannten Korrekturströme konstant gehalten werden, so daß der genannte eine Korrekturstrom eine Vielzahl von verschiedenen Werten annimmt;

(b) für jeden verschiedenen Wert des genannten einen Korrekturstromes, Berechnen eines entsprechenden Wertes einer Kombinationsschärfe (P'') des Elektronenstrahls (8), welche Kombinationsschärfe definiert ist durch die Summe der Quadrate $(|p_x| + |p_y|)$ von Maßen $(p_x, p_y)$ der transversalen Dimensionen des Strahlenpunktes in X- bzw. Y-Richtung bei dem genannten vorbestimmten Ort (X, Y);

(c) Bestimmen eines optimalen Wertes des genannten einen Korrekturstroms in Abhängigkeit von den berechneten Werten der Kombinationsschärfe;

(d) zweifache Wiederholung der Schritte (a) bis (c) in Folge, jedoch Variieren eines zweiten der genannten Korrekturströme während der ersten Wiederholung und eines dritten der genannten Korrekturströme bei der zweiten Wiederholung, Konstanthalten der anderen beiden der genannten beiden Korrekturströme bei jeder Wiederholung;

(e) Durchführen der Schritte (a) bis (d) in Folge, ein oder mehrere Male, bis die erhaltenen Werte der genannten Korrekturströme auf einen Satz von stabilen Werten konvergieren.

4. Verfahren nach Anspruch 1, 2 oder 3, bei dem optimale Werte von dem oder jedem Korrekturstrom $(I_x, I_y, I_F)$ in Bezug auf jeden der Vielzahl von vorbestimmten Matrixpunkten in einem Feld erhalten wird, über welchem der Elektronenstrahl im Verlauf der Abtastung der Oberfläche der Probe abgelenkt werden soll, und Korrekturströme für andere Punkte in dem Feld aus den so ermittelten optimalen Werten bestimmt werden.

5. Verfahren nach einem der vorhergehenden Ansprüche, bei dem die erhaltenen optimalen Werte von dem oder jedem Korrekturstrom in einer Speichereinrichtung gespeichert und durch neue optimale Werte, die nacheinander ermittelt werden, ersetzt werden, z.B. dann, wenn die Vorrichtung nachgeeicht wird.

6. Verfahren nach einem der vorhergehenden Ansprüche, bei dem der genannte eine Korrekturstrom in einem Schritt (a) in Schritten von einer solchen Größe verändert wird, daß der gemessene Wert der kombinierten Schärfe um ungefähr 5% bis 10% variiert, zwischen einem Wert von dem genannten Korrekturwert, z.B. einem optimalen Wert, der zuvor in der Speichereinrichtung nach Anspruch 5 gespeichert wurde, und dem Wert, zu dem der genannte eine Korrekturstrom beim nächsten Schritt gebracht wird.

7. Verfahren nach einem der vorhergehenden Ansprüche, bei dem, zur Messung eines Wertes der Kombinationsschärfe, die Messungen der transversalen Dimensionen des Strahlenpunkts in X-Richtung und Y-Richtung durchgeführt werden durch Messen der Variation von gestreuten Elektronen oder Sekundärelektronen von der Oberfläche einer Probe (50), oder der Variation von durch die Probe (50) hindurchgetretenen Elektronen, wenn der Elektronenstrahl quer über eine Kante einer Testmarke abgelenkt wird, welche auf der Probe (50) vorgesehen ist.

8. Verfahren nach einem der vorhergehenden Ansprüche, bei dem der Elektronenstrahl auf der Probe in Y-Richtung verlängert wird, wenn die transversale Dimension des Punktes in X-Richtung ($p_x$) gemessen wird, und der Elektronenstrahlpunkt auf der Probe in X-Richtung verlängert wird, wenn die transversale Dimension des Punktes in Y-Richtung ($p_y$) gemessen wird.

9. Verfahren nach einem der vorhergehenden Ansprüche, bei dem der optimale Wert des genannten einen Korrekturstromes in einem Schritt (c) durch Approximation der gemessenen Werte der Kombinierten Schärfe einer quadratischen Kurve durch ein Verfahren der kleinsten Quadrate bestimmt wird.

**Revendications**

1. Un procédé d'étalonnage d'un appareil à faisceau d'électrons, cet appareil étant capable de balayer la surface d'un échantillon (2, 50) avec un faisceau d'électrons (8) dans une direction X, et dans une direction Y orthogonale à la direction X, l'étalonnage étant accompli en déterminant des valeurs optimales de courants de correction respectifs ($I_x$, $I_y$, $I_F$) à appliquer à des bobines de correction (10X, 10Y, 11) qui sont incorporées dans l'appareil, pour corriger l'aberration due respectivement à l'astigmatisme dans la direction X, à l'astigmatisme dans la direction Y et à la courbure de champ du foyer, le procédé comprenant les étapes suivantes: on dirige le faisceau d'électrons vers une position prédéterminée (X, Y) sur la surface précitée, et

(a) on fait varier un premier des courants de correction, tout en maintenant constants les deux autres courants de correction, afin que le premier courant de correction prenne un ensemble de valeurs différentes;

(b) pour chaque valeur différente du premier courant de correction, on calcule une valeur correspondante d'une finesse combinée (P) du faisceau d'électrons (8), cette finesse combinée étant définie par le produit ($p_x \times p_y$) de mesures ($p_x$, $p_y$) des dimensions transversales de la trace du faisceau dans les directions respectives X et Y, à la position prédéterminée (X, Y);

(c) on détermine une valeur optimale du premier courant de correction, sous la dépendance des valeurs calculées de la finesse combinée;

(d) on répète deux fois successivement les étapes (a) à (c), mais en faisant varier au cours de la première répétition un second des courants de correction, et au cours de la seconde répétition un troisième des courants de correction, en maintenant les deux autres courants de correction constants au cours de chaque répétition;

(e) on accomplit une ou plusieurs fois, successivement, les étapes (a) à (d), jusqu'à ce que les valeurs obtenues des courants de correction convergent vers un ensemble de valeurs stables.

2. Un procédé d'étalonnage d'un appareil à faisceau d'électrons, cet appareil étant capable de balayer la surface d'un échantillon (2, 50) avec un faisceau d'électrons (8) dans une direction X, et dans une direction Y orthogonale à la direction X, l'étalonnage étant accompli en déterminant des valeurs optimales de courants de correction respectifs ($I_x$, $I_y$, $I_F$) à appliquer à des bobines de correction (10X, 10Y, 11) qui sont incorporées dans l'appareil, pour corriger l'aberration due respectivement à l'astigmatisme dans la direction X, à l'astigmatisme dans la direction Y et à la courbure de champ du foyer, le procédé comprenant les étapes suivantes: on dirige le faisceau d'électrons vers une position prédéterminée (X, Y) sur la surface précitée, et

(a) on fait varier un premier des courants de correction, tout en maintenant constants les deux autres courants de correction, afin que le premier courant de correction prenne un ensemble de valeurs différentes;

(b) pour chaque valeur différente du premier courant de correction, on calcule une valeur correspondante d'une finesse combinée (P') du faisceau d'électrons (8), cette finesse combinée étant définie par la somme des carrés ($p_x^2 + p_y^2$) de mesures ($p_x$, $p_y$) des dimensions transversales de la trace du faisceau dans les directions respectives X et Y, à la position prédéterminée (X, Y);

(c) on détermine une valeur optimale du premier courant de correction, sous la dépendance des valeurs calculées de la finesse combinée;

(d) on répète deux fois successivement les étapes (a) à (c), mais en faisant varier ou cours de la première répétition un second des courants de correction, et au cours de la seconde répétition un troisième des courants de correction, en maintenant les deux autres courants de correction constants au cours de chaque répétition;

(e) on accomplit une ou plusieurs fois, successivement, les étapes (a) à (d), jusqu'à ce que les valeurs obtenues des courants de correction convergent vers un ensemble de valeurs stables.

3. Un procédé d'étalonnage d'un appareil à faisceau d'électrons, cet appareil étant capable de balayer la surface d'un échantillon (2, 50) avec un faisceau d'électrons (8) dans une direction X, et dans une direction Y orthogonale à la direction X, l'étalonnage étant accompli en déterminant des valeurs optimales de courants de correction respectifs ($I_x$, $I_y$, $I_F$) à appliquer à des bobines de correction (10X, 10Y, 11) qui sont incorporées dans l'appareil, pour corriger l'aberration due respectivement à l'astigmatisme dans la direction X, à l'astigmatisme dans la direction Y et à la courbure de champ du foyer, le procédé comprenant les étapes suivantes: on dirige le faisceau d'électrons vers une position prédéterminée (X, Y) sur la surface précitée, et

(a) on fait varier un premier des courants de correction, tout en maintenant constants les deux autres courants de correction, afin que le premier courant de correction prenne un ensemble de valeurs différentes;

(b) pour chaque valeur différente du premier courant de correction, on calcule une valeur correspondante d'une finesse combinée (P'') du faisceau d'électrons (8), cette finesse combinée étant définie par la somme des valeurs absolues ($|p_x|+|p_y|$) de mesures ($p_x$, $p_y$) des dimensions transversales de la trace du faisceau, respectivement dans les directions X et Y, à la position prédéterminée (X, Y);

(c) on détermine une valeur optimale du premier courant de correction, sous la dépendance des valeurs calculées de la finesse combinée,

(d) on répète deux fois successivement les étapes (a) à (c), mais en faisant varier ou cours de la première répétition un second des courants de correction, et au cours de la seconde répétition un troisième des courants de correction, en maintenant les deux autres courants de correction constants au cours de chaque répétition;

(e) on accomplit une ou plusieurs fois, successivement, les étapes (a) à (d), jusqu'à ce que les valeurs obtenues des courants de correction convergent vers un ensemble de valeurs stables.

4. Un procédé selon la revendication 1, 2 ou 3, dans lequel les valeurs optimales du ou de chaque courant de correction ($I_x$, $I_y$, $I_F$) sont obtenues pour chaque point d'un ensemble de points de matrice prédéterminés dans un champ sur lequel le faisceau d'électrons doit être dévié au cours du balayage de la surface d'un échantillon, et des courants de correction pour d'autres points du champ sont déterminés à partir des valeurs optimales ainsi obtenues.

5. Un procédé selon l'une quelconque des revendications précédentes, dans lequel des valeurs optimales obtenues pour le ou chaque courant de correction sont enregistrées dans des moyens de mémoire, et sont remplacées par de nouvelles valeurs optimales obtenues ultérieurement, par exemple lorsque l'appareil est réétalonné.

6. Un procédé selon l'une quelconque des revendications précédentes, dans lequel, à l'étape (a), on fait varier le premier courant de correction par incréments d'une taille telle que la valeur mesurée de la finesse combinée varie d'environ 5% à 10% entre une valeur du premier courant de correction, par exemple une valeur optimale enregistrée précédemment dans des moyens de mémoire conformément à la revendication 5, et la valeur à laquelle ce premier courant de correction est ensuite amené.

7. Un procédé selon l'une quelconque des revendications précédentes dans lequel, pour mesurer une valeur de la finesse combinée, on effectue des mesures des dimensions transversales de la trace du faisceau dans la direction X et dans la direction Y, en mesurant la variation d'électrons diffusés ou d'électrons secondaires provenant de la surface d'un échantillon (50), ou la variation d'électrons qui sont transmis à travers l'échantillon (50), lorsque le faisceau d'électrons est dévié de façon à franchir un bord d'une marque de test qui est formée sur l'échantillon (50).

8. Un procédé selon l'une quelconque des revendications précédentes, dans lequel la trace du faisceau d'électrons sur l'échantillon est allongée dans la direction Y lorsqu'on mesure la dimension transversale de la trace dans la direction X ($p_x$), et la trace du faisceau d'électrons sur l'échantillon est allongée dans la direction X lorsqu'on mesure la dimension transversale de la trace dans la direction Y ($p_y$).

9. Un procédé selon l'une quelconque des revendications précédentes, dans lequel on détermine la valeur optimale du premier courant de correction, à l'étape (c), par une méthode d'approximation au sens des moindres carrés qui définit une courbe du second degré constituant une approximation des valeurs mesurées de la finesse combinée.

## FIG. 1 (a)

EP 0 148 784 B1

FIG. 1

(b)

(c)

FIG. 2

# FIG. 3

(a)

(b)

8′

8

12

13

# FIG. 4

EP 0 148 784 B1

# FIG. 5

# FIG. 6

## FIG. 7

## FIG. 8

## FIG. 9